Europäisches Patentamt

European Patent Office

Office européen des brevets

(19)

(11) Veröffentlichungsnummer: **0 066 904**
**B1**

(12) **EUROPÄISCHE PATENTSCHRIFT**

(45) Veröffentlichungstag der Patentschrift:
21.08.85

(51) Int. Cl.⁴: **H 03 F 3/217**

(21) Anmeldenummer: 82200509.6

(22) Anmeldetag: **29.04.82**

(54) **Schaltverstärker.**

(30) Priorität: 01.06.81 CH 3578/81

(43) Veröffentlichungstag der Anmeldung:
15.12.82 Patentblatt 82/50

(45) Bekanntmachung des Hinweises auf die Patenterteilung:
21.08.85 Patentblatt 85/34

(84) Benannte Vertragsstaaten:
CH DE FR GB LI NL

(56) Entgegenhaltungen:
EP - A - 0 025 234
DE - A - 2 939 365
FR - A - 2 340 644
GB - A - 2 064 901
US - A - 3 480 881
US - A - 4 153 882

H.SCHMID: "Electronic analog/digital conversions",
1970, Van Nostrand Reinhold Company, Seiten 220-223,
New York, USA

(73) Patentinhaber: BBC Aktiengesellschaft Brown, Boveri &
Cie., Haselstrasse, CH-5401 Baden (CH)

(72) Erfinder: Furrer, Andreas, Guggimoos 397,
CH-5425 Schneisingen (CH)

## Beschreibung

Die vorliegende Erfindung betrifft einen Schaltverstärker für analoge NF-Signale gemäß dem Oberbegriff des Anspruchs 1.

Der Anmelder hat sich unter Bezugnahme auf die älteren Anmeldungen GB-A-2 064 901 und DE-A1-3 044 956 freiwillig eingeschränkt und gesonderte Patentansprüche für die Vertragsstaaten Großbritannien und Bundesrepublik Deutschland vorgelegt.

Schaltverstärker der beschriebenen Art weisen einen hohen Wirkungsgrad auf, weshalb sie mit besonderem Vorteil für Verstärker mit großer Ausgangsleistung verwendet werden. Beispielsweise ist in der DE-A1-2 935 445 (entspricht EP-A-0 025 234) ein Schaltverstärker beschrieben, der als Modulationsverstärker für einen Rundfunksender vorgesehen ist. Dazu enthält dieser Schaltverstärker eine Mehrzahl nebeneinander angeordneter Verstärkerstufen, von denen jede zwei Transformatoren aufweist, deren Primärwicklungen über zugeordnete Schaltelemente mit einer Gleichspannungsquelle verbindbar sind und deren Sekundärwicklungen an eine Diodenkaskade angeschlossen sind. Das zu verstärkende analoge NF-Eingangssignal wird in bekannter Weise in zwei Impulszüge gewandelt, deren dauermodulierte Impulse um 180° phasenverschoben sind. Die Impulse jedes Impulszugs steuern das Schaltelement für einen der Transformatoren in jeder Verstärkerstufe. Durch das damit bewirkte alternierende Erregen der beiden Transformatoren jeder Verstärkerstufe kann die Sättigung dieser Transformatoren vermieden und eine 100%ige Aussteuerung der Verstärkerstufen erreicht werden. Es versteht sich, daß bei dieser Betriebsweise während jeder Periode des A/D-Wandlers die Schaltelemente und Transformatoren jeder Verstärkerstufe einmal eingeschaltet bzw. erregt werden, wobei die Einschalt- bzw. Erregungsdauer sehr kurz sein kann.

Um die Schaltverluste zu verringern, ist darum auch schon ein anderes Betriebsverfahren für Schaltverstärker vorgeschlagen worden (CH-Patentgesuch 992/81-2). Bei diesem Verfahren wird das analoge NF-Eingangssignal ebenfalls in einem A/D-Wandler periodisch abgetastet, und es werden eine dem Momentanwert der Amplitude des Analogsignals entsprechende Anzahl Impulse gleicher Dauer erzeugt. Jedem Impuls ist eine Verstärkerstufe zugeordnet, und jeder Impuls wird in zwei Teilimpulse zerlegt, die alternierend die mit den beiden Transformatoren dieser Verstärkerstufe zusammenwirkenden Schaltelemente steuern. Die zeitliche Dauer jedes Impulses bzw. Teilimpulses ist so gewählt, daß der Transformator während einer maximalen Dauer erregt wird, ohne in die Sättigung zu laufen. Bei diesem Betriebsverfahren werden während jeder Periode des A/D-Wandlers nur so viele Schaltelemente und Transformatoren eingeschaltet bzw. erregt, wie dem Momentanwert des Analogsignals entsprechen, was eine wesentliche Verringerung der Schaltverluste ermöglicht.

Der bekannte Schaltverstärker benötigt für die beiden beschriebenen Betriebsweisen in jeder Verstärkerstufe zwei alternierend einschaltbare Transformatoren. Der dafür erforderliche Materialaufwand und die Schaltverluste sind um so größer, je größer die angestrebte Ausgangsleistung ist.

Es ist weiterhin aus der Technik der Leistungsverstärker bekannt (DE-A2-2 939 365), in einer einzelnen Verstärkerstufe eine transformatorlos gleichgerichtete Netzspannung über zwei im Gegenkontakt arbeitende, pulsdauermoduliert angesteuerte Leistungshalbleiter auf eine am Ausgang liegende Last zu schalten. Wegen der fehlenden galvanischen Trennung kann eine Mehrzahl solcher Verstärkerstufen jedoch nicht in Kaskaden geschaltet werden.

Der vorliegenden Erfindung liegt darum die Aufgabe zugrunde, einen Schaltverstärker zu schaffen, dessen Verstärkerstufen für eine 100%ige Aussteuerung nur einen Transformator und nur ein Schaltelement benötigen und dessen Transformator auch während mehrerer aufeinanderfolgender Perioden des A/D-Wandlers erregt werden kann.

Erfindungsgemäß wird diese Aufgabe bei einem Schaltverstärker der eingangs genannten Art durch die Merkmale aus dem Kennzeichen des Anspruchs 1 gelöst.

Der neue Schaltverstärker ermöglicht, die Anzahl der für eine vorgegebene Ausgangsleistung erforderlichen Transformatoren auf die Hälfte und die Anzahl der zugeordneten Schaltelemente auf ein Viertel zu reduzieren und damit sowohl den materiellen Aufwand als auch die Schaltverluste zu verringern. Weiter kann für den neuen Schaltverstärker ein kleineres Tiefpaßfilter verwendet werden, weil während jeder Wandelperiode nicht mehr zwei um 180° phasenverschobene Impulse erzeugt bzw. die Impulse nicht mehr in zwei Teilimpulse zerlegt werden müssen. Schließlich ermöglicht der neue Schaltverstärker auch eine bessere Qualität des NF-Ausgangssignals, weil die verringerte Anzahl der Schaltvorgänge auch eine Verkleinerung des Klirrfaktors und Verringerung des Rauschens zur Folge hat.

Nachfolgend wird ein bevorzugtes Ausführungsbeispiel des neuen Schaltverstärkers mit Hilfe der Figuren beschrieben. Es zeigt

Fig. 1 das vereinfachte Blockschaltbild einer Ausführungsform des neuen Schaltverstärkers und

Fig. 2 und 3 das Schaltbild einer ersten und einer zweiten Ausführungsform der Verstärkerstufe für den neuen Schaltverstärker.

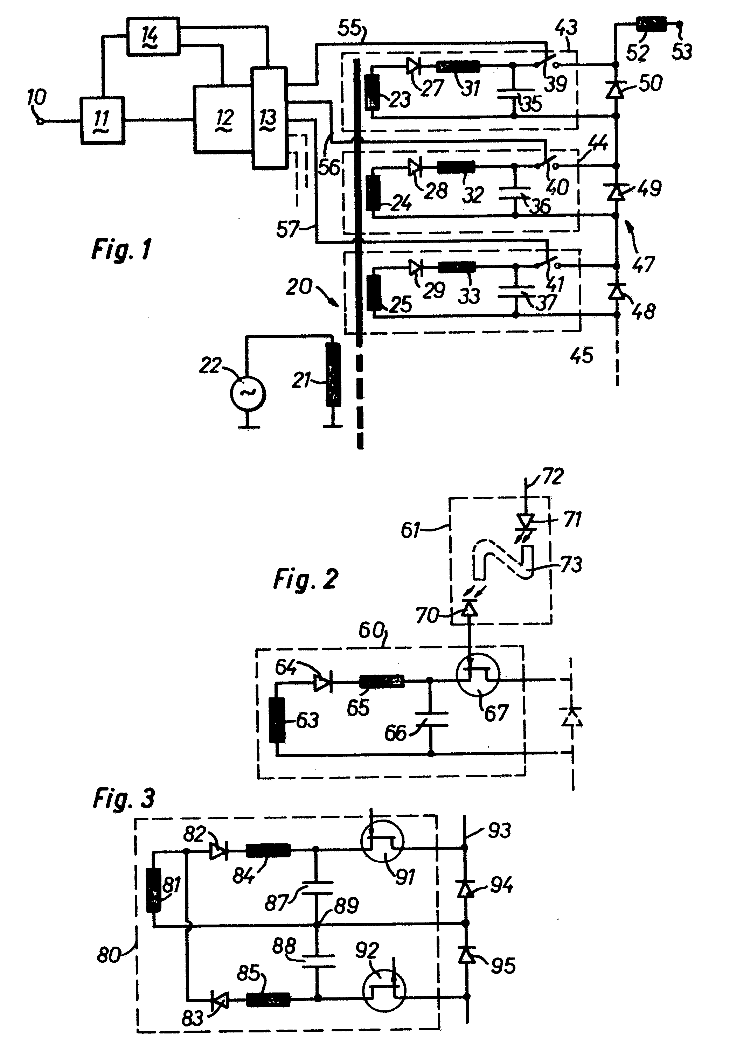

Bei der in Fig. 1 in einem stark vereinfachten Blockschaltbild gezeigten Ausführungsform eines Schaltverstärkers ist die Eingangsklemme 10 für das zu verstärkende analoge NF-Eingangssignal mit dem Eingang eines A/D-Wandlers 11 verbunden. Dem A/D-Wandler ist ein Speicher 12 nachgeschaltet, dem eine steuerbare Ausspeicherschaltung 13, die eine Mehrzahl Ausgänge aufweist, zugeordnet ist. Weiter ist ein Taktgenerator 14 vorgesehen, der die Zeittakte für die Wandlung des analogen Eingangssignals in digitale Signale und für die Ausgabe der Steuersignale liefert.

Der Schaltverstärker enthält weiter einen Transformator 20, dessen Primärwicklung 21 an eine Wechselspannungsquelle 22 angeschlossen ist. Der Transformator weist mehrere Sekundärwicklungen auf, von denen der einfacheren Darstellung wegen nur drei Sekundärwicklungen 23, 24, 25 gezeigt sind. Jede Sekundärwicklung ist mit einer Gleichrichterschaltung verbunden, die aus einem Einweggleichrichter 27, 28 bzw. 29 einer in Serie geschalteten Drossel 31, 32 bzw. 33 und einem Glättungskondensator 35, 36 bzw. 37 besteht. Der eine Ausgang der Gleichrichterschaltung ist mit einem steuerbaren Schaltelement 39, 40 bzw. 41 verbunden. Jede Sekundärwicklung bildet mit der zugeordneten Gleichrichterschaltung und dem Schaltelement eine Verstärkerstufe 43, 44 bzw. 45, deren Ausgänge an eine Diodenkaskade 47 angeschlossen sind. Die Diodenkaskade enthält zwischen den Anschlüssen jeder Verstärkerstufe eine Diode 48, 49, 50. Das Ende der Diodenkaskade ist über ein Tiefpaßfilter 52 mit der Ausgangsklemme 53 des Verstärkers verbunden.

Die Ausspeicherschaltung 13 enthält für jede der Verstärkerstufen einen getrennten Ausgang, der mittels einer Signalleitung 55, 56 bzw. 57 mit dem Schaltelement der zugeordneten Verstärkerstufe verbunden ist.

Zum Betrieb des beschriebenen Verstärkers wird die Primärwicklung 21 des Transformators 20 an die Wechselspannungsquelle 22 angeschlossen. Dann wird in jeder Sekundärwicklung 23, 24, 25 eine Wechselspannung induziert, die vom zugeordneten Gleichrichter 27, 28 bzw. 29 gleichgerichtet wird und den Kondensator 35, 36 bzw. 37 auf die entsprechende Gleichspannung ladet.

Für die weitere Beschreibung sei angenommen, daß alle Schaltelemente 39, 40, 41 ausgeschaltet sind und darum kein Strom von den Verstärkerstufen 43, 44 bzw. 45 zur Diodenkaskade 47 fließt.

Das von der Eingangsklemme an den A/D-Wandler 11 geleitete Analogsignal wird in vorgegebenen zeitlichen Abständen abgetastet und dabei ein dem Momentanwert der Amplitude entsprechendes digitales Signal erzeugt, das in den Speicher 12 eingespeichert wird. Bei einer bevorzugten Betriebsweise wird der maximal wandelbare Spannungswert der Amplitude in Spannungsbereiche unterteilt, deren Anzahl gleich der Anzahl der Verstärkerstufen ist. Das digitale Ausgangssignal des Wandlers ist dann eine Zahl, die gleich der Anzahl der Spannungsbereiche ist, die dem Momentanwert der Amplitude des Analogsignal entsprechen. Dieses Digitalsignal setzt im Speicher 12 eine seiner Zaghl gleiche Anzahl Speicherplätze. Die Ausspeicherschaltung 13 liest periodisch den Speicherinhalt aus und erzeugt für den gesetzten Speicherplatz ein Einschaltsignal, das auf eine der Signalleitungen 55, 56, 57 gegeben und an das entsprechende Schaltelement 39, 40 bzw. 41 geleitet wird.

Auf diese Weise wird eine dem Momentanwert der Amplitude des Analogsignals entsprechende Anzahl Schaltelement ein- und die an den zugeordneten Kondensatoren liegender Gleichspannungen längs der Diodenkaskade in Serie geschaltet. Dabei entsteht für die Zeitspanne zwischen zwei Schalttakten über der Diodenkaskade eine Spannung, die der Summe der im A/D-Wandler bestimmten Spannungsbereiche das analogen Eingangssignals proportional ist. Die beim Ein- und Ausschalten von Schaltelementen über der Diodenkaskade entstehenden Spannungssprünge werden vom Tiefpaßfilter 52 ausgeglichen, so daß an der Ausgangsklemme 53 ein Analogsignal erscheint, das dem verstärkten Eingangssignal entspricht.

Um die Belastung der einzelnen Verstärkerstufen gleichmäßig zu verteilen, ist es vorteilhaft, für die meisten Verstärkerstufen die gleiche Ausgangsspannung zu wählen.

Darüber hinaus kann wenigstens eine Verstärkerstufe in weitere Unterstufen unterteilt werden, deren Ausgangsspannungen binär gewichtet sind und die von einem entsprechenden, binär codierten Signal der Ausspeicherschaltung 13 angesteuert werden. Auf diese Weise können die an der Diodenkaskade auftretenden Spannungsstufen und damit die verstärkerbedingte Welligkeit des Ausgangssignals verkleinert werden.

Es versteht sich, daß der Transformator einfacherweise an eine technische Wechselspannungsquelle angeschlossen werden kann mit beispielsweise 220 V/50 Hz. Es ist aber auch möglich, einen Drehstromtransformator für 380 V/50 Hz zu verwenden. Im letzteren Fall bestehen die in Fig. 1 gezeigte Primär- und die Sekundärwicklungen aus drei Wicklungsteilen, und die Gleichrichtereinrichtung ist entsprechend als Dreiphasen-Gleichrichter ausgebildet.

Es versteht sich weiter, daß anstelle des gezeigten einen Transformators mit einer Primär- und einer Mehrzahl Sekundärwicklungen auch eine Mehrzahl Transformatoren mit je einer Primär- und einer Sekundärwicklung verwendet werden können.

Um eine verbesserte Übereinstimmung des Verlaufs des analogen Eingangssignals mit der Hüllkurve der über der Diodenkaskade addierten Gleichspannungen zu erreichen, kann dem A/D-Wandler 11 ein Rechenwerk nachgeschaltet werden, das die Differenz zwischen dem Momentanwert der Amplitude des analogen Eingangssignals und dem aus den Spannungsbereichen gebildeten nächstliegenden Digitalwert bestimmt und über die Ausspeicherschaltung 13 ein zusätzliches, zeitlich verzögertes Steuersignal erzeugt, wobei die zeitliche Verzögerung der bestimmten Differenz umgekehrt proportional ist. Besonders vorteilhaft ist es, wenn bei aufeinanderfolgenden Ausspeichertakten nur solche Ein- oder Ausschaltsignale erzeugt werden, die der inzwischen erfolgten Änderung des analogen Eingangssignals entsprechen. Das ermöglicht, die Gesamtzahl der Schaltvorgänge und die damit verbundenen Schaltverluste ganz wesentlich zu verringern. Solche Betriebsarten sind in dem eingangs erwähnten CH-Patentgesuch beschrieben, weshalb auf deren ausführliche Diskussion verzichtet wird.

Damit die von den Verstärkerstufen erzeugten Spannungen längs der Diodenkaskade addiert werden können, darf nur eine Verstärkerstufe mit der Masseleitung verbunden sein. Jede der weiteren »schwimmenden« Verstärkerstufen liegt auf einer höheren Spannung, deren Wert veränderlich ist und von der Anzahl der eingeschalteten Verstärkerstufen und der Ordnungszahl der einzelnen Verstärkerstufe längs der Diodenkaskade abhängig ist. Demgegenüber weisen die von der Ausspeicherschaltung erzeugten Schaltsignale eine konstante Spannung gegen die Masseleitung auf, weshalb die Schaltsignale nicht direkt an die Schaltelemente geleitet werden können. Fig. 2 zeigt eine Verstärkerstufe 60 und eine als Fotokoppler 61 ausgebildete Anordnung zum galvanischen Trennen der Signalleitung vom Schaltelement. Die Verstärkerstufe enthält in Übereinstimmung mit den Ausführungsformen gemäß der Fig. 1 eine Sekundärwicklung 63, einen Gleichrichter 64, eine Drossel 65, einen Glättungskondensator 66 und einen Schalter 67. Der Schalter ist ein Feldeffekttransistor, dessen Gate mit der Fotodiode 70 des Fotokopplers verbunden ist. Die Leichtdiode 71 des Fotokopplers ist mit einer Signalleitung 72 verbunden. Damit auch bei großen Spannungsunterschieden eine sichere Isolation zwischen der Leuchtdiode und der Fotodiode gewährleistet ist, kann zum Übertragen des Lichts ein Faserlichtleiter 73 verwendet werden.

Anstelle des gezeigten Feldeffekttransistors können auch andere Halbleiterbauelemente, beispielsweise ein Bipolartransistor, verwendet werden. Weiter kann zwischen der Fotodiode und dem Schalter ein Verstärker angeschlossen werden, wenn das Ausgangssignal der Fotodiode das direkte Steuern des Schalters nicht ermöglicht.

Die in den Fig. 1 und 2 gezeigte einphasige Gleichrichterschaltung ist einfacherweise als Einweggleichrichtung ausgebildet. Es versteht sich, daß zum Vermindern des Rippels der Gleichspannung auch eine Mittelpunkt- bzw. Doppelwegschaltung oder eine Doppelweg-Grätzschaltung verwendet werden kann.

Wird, wie weiter oben erwähnt, ein Dreiphasentransformator verwendet und enthält die Verstärkerstufe eine dreiteilige Sekundärwicklung, dann kann anstelle des ebenfalls erwähnten Dreiphasen-Brückengleichrichters auch eine Stern- oder Doppelstern-Gleichrichterschaltung verwendet werden.

In Fig. 3 ist eine weitere Ausführungsform einer Verstärkerstufe 80 gezeigt, deren Gleichrichtereinrichtung zur Spannungsverdopplung als Zweiweg-Gleichrichter ausgebildet ist. Dazu ist das eine Ende der Sekundärwicklung 81 über zwei antiparallel geschaltete Dioden 82, 83 und zugehörige Drosseln 84 bzw. 85 mit den einen Anschlüssen zweier Kondensatoren 87 bzw. 88 und das andere Ende der Sekundärwicklung direkt mit dem Verbindungspunkt 89 der anderen Anschlüsse der Kondensatoren verbunden. Der eine Anschluß jedes Kondensators ist weiter über ein Schaltelement 91 bzw. 92, und der Verbindungspunkt 89 der beiden anderen Kondensatoranschlüsse ist direkt an die Diodenkaskade 93 geführt, die zwischen den einzelnen Anschlüssen je eine Diode 94, 95 aufweist.

Die gezeigte einphasige Gleichrichtereinrichtung mit Zweiweggleichrichtung kann, wie die oben beschriebene Einrichtung mit Einweggleichrichtung, auch als Mittelpunktschaltung ausgeführt werden und für einen Dreiphasentransformator als Stern- oder Doppelstern-Gleichrichterschaltung.

**Patentansprüche für die Vertragsstaaten: DE, GB**

1. Schaltverstärker für analoge NF-Signale, mit einem A/D-Wandler (11), der das analoge NF-Signal in mindestens zwei Impulsfolgen wandelt, und mit mindestens zwei Verstärkerstufen (43, 44, 45) von denen jede einen Transformator (20) enthält, dessen Primärwicklung (21) mit einer Spannungsquelle und dessen Sekundärwicklung mit einer Diodenkaskade verbunden ist, und mindestens ein von der Impulsfolge gesteuertes Schaltelement für den von der Spannungsquelle an die Diodenkaskade zu übertragenden Strom, sowie mit einem an die Diodenkaskade angeschlossenen Tiefpaßfilter, dadurch gekennzeichnet, daß die Primärwicklung (21) des Transformators (20) mit einer Wechselspannungsquelle (22) verbunden ist und die Verstärkerstufe (43, 44, 45) eine an die Sekundärwicklung (23, 24, 25) des Transformators (20) angeschlossene Gleichrichterschaltung (27, 31, 35; 28, 32, 36; 29, 33, 37) enthält, daß die Gleichrichterschaltung (27, 31, 35; 28, 32, 36; 29, 33, 37) wenigstens zwei Ausgänge aufweist, von denen der eine über das Schaltelement (39, 40, 41) und der andere direkt an die Diodenkaskade (47) angeschlossen und zwischen den beiden Anschlußpunkten mindestens eine Diode (50, 49, 48) vorgesehen ist, und daß die Transformatoren der Verstärkerstufen (43, 44, 45) zu einem Transformator (20) mit einer Primärwicklung (21) und einer der Anzahl der Verstärkerstufen (43, 44, 45) entsprechenden Zahl von Sekundärwicklungen (23, 24, 25) zusammmengefaßt sind.

2. Schaltverstärker nach Anspruch 1, dadurch gekennzeichnet, daß die Gleichrichterschaltung drei Ausgänge aufweist, von denen zwei über ein Schaltelement (91, 92) und der dritte direkt an die Diodenkaskade (93) angeschlossen sind, die zwischen dem einen und dem dritten sowie zwischen dem dritten und dem anderen Anschlußpunkt mindestens eine Diode (94, 95) aufweist.

3. Schaltverstärker nach Anspruch 1, dadurch gekennzeichnet, daß die Ausgangsspannungen der meisten Verstärkerstufen gleich sind.

4. Schaltverstärker nach Anspruch 1, dadurch gekennzeichnet, daß wenigstens eine Verstärkerstufe in Unterstufen unterteilt ist und die Ausgangsspannungen der Unterstufen binär gewichtet sind.

5. Schaltverstärker nach Anspruch 1, dadurch gekennzeichnet, daß zum galvanischen Trennen der Steuerelektrode des Schaltelements (67) von der Steuerimpulsleitung (72) eine Einrichtung (71) zum Wandeln der elektrischen Steuerimpulse in optische Signale und eine weitere Einrichtung (70) zum Rückwandeln der optischen Signale in elektrische Steuerimpulse vorgesehen ist.

6. Schaltverstärker nach Anspruch 6, dadurch gekennzeichnet, daß zwischen der einen und der weiteren Einrichtung (71 bzw. 70) ein Lichtleiter (73) angeordnet ist.

7. Schaltverstärker nach Anspruch 1, dadurch gekennzeichnet, daß zum galvanischen Trennen der Steuerelektrode der Schaltelemente von der Steuerimpulsleitung eine Einrichtung zum Wandeln der elektrischen Steuerimpulse in optische Signale und mit optischen Signalen steuerbare Schaltelemente vorgesehen sind.

**Patentansprüche für die Vertragsstaaten: CH, FR, LI, NL**

1. Schaltverstärker für analoge NF-Signale, mit einem A/D-Wandler (11), der das analoge NF-Signal in mindestens zwei Impulsfolgen wandelt, und mit mindestens zwei Verstärkerstufen (43, 44, 45) von denen jede einen Transformator (20) enthält, dessen Primärwicklung (21) mit einer Spannungsquelle und dessen Sekundärwicklung mit einer Diodenkaskade verbunden ist, und mindestens ein von der Impulsfolge gesteuertes Schaltelement für den von der Spannungsquelle an die Diodenkaskade zu übertragenden Strom, sowie mit einem an die Diodenkaskade angeschlossenen Tiefpaßfilter, dadurch gekennzeichnet, daß die Primärwicklung (21) des Transformators (20) mit einer Wechselspannungsquelle (22) verbunden ist und die Verstärkerstufe (43, 44, 45) eine an die Sekundärwicklung (23, 24, 25) des Transformators (20) angeschlossene Gleichrichterschaltung (27, 31, 35; 28, 32, 36; 29, 33, 37) enthält, und daß die Gleichrichterschaltung (27, 31, 35; 28, 32, 36; 29, 33, 37) wenigstens zwei Ausgänge aufweist, von denen der eine über das Schaltelement (39, 40, 41) und der andere direkt an die Diodenkaskade (47) angeschlossen und zwischen den beiden Anschlußpunkten mindestens eine Diode (50, 49, 48) vorgesehen ist.

2. Schaltverstärker nach Anspruch 1, dadurch gekennzeichnet, daß die Gleichrichterschaltung drei Ausgänge aufweist, von denen zwei über ein Schaltelement (91, 92) und der dritte direkt an die Diodenkaskade (93) angeschlossen sind, die zwischen dem einen und dem dritten sowie zwischen dem dritten und dem anderen Anschlußpunkt mindestens eine Diode (94, 95) aufweist.

3. Schaltverstärker nach Anspruch 1, dadurch gekennzeichnet, daß die Transformatoren der Verstärkerstufen (43, 44, 45) zu einem Transformator (20) mit einer Primärwicklung (21) und einer der Anzahl der Verstärkerstufen (43, 44, 45) entsprechenden Zahl von Sekundärwicklungen (23, 24, 25) zusammengefaßt sind.

4. Schaltverstärker nach Anspruch 1, dadurch gekennzeichnet, daß die Ausgangsspannungen der meisten Verstärkerstufen gleich sind.

5. Schaltverstärker nach Anspruch 1, dadurch gekennzeichnet, daß wenigstens eine Verstärkerstufe in Unterstufen unterteilt ist und die Ausgangsspannungen der Unterstufen binär gewichtet sind.

6. Schaltverstärker nach Anspruch 6, dadurch gekennzeichnet, zum galvanischen Trennen der Steuerelektrode des Schaltelements (67) von der Steuerimpulsleitung (72) eine Einrichtung (71) zum Wandeln der elektrischen Steuerimpulse in optische Signale und eine weitere Einrichtung (70) zum Rückwandeln in der optischen Signale in elektrische Steuerimpulse vorgesehen ist.

7. Schaltverstärker nach Anspruch 6, dadurch gekennzeichnet, daß zwischen der einen und der weiteren Einrichtung (71 bzw. 70) ein Lichtleiter (73) angeordnet ist.

8. Schaltverstärker nach Anspruch 1, dadurch gekennzeichnet, daß zum galvanischen Trennen der Steuerelektrode der Schaltelemente von der Steuerimpulsleitung eine Einrichtung zum Wandlen der elektrischen Steuerimpulse in optische Signale und mit optischen Signalen steuerbare Schaltelemente vorgesehen sind.

**Claims for the contraction states DE and GB**

1. Switching amplifier for analogu LF signals, having an A/D converter (11) which converts the analog LF signal into at least two pulse sequences, and at least two amplifier states (42, 44, 45), each of which contains a tranformer (20) the primary winding (21) of which is connected to a voltage source and the secondary winding of which is connected to a cascaded diode circuit, and at least one switching element, which is controlled by the pulse sequence, for the current to be transferred from the voltage source to the cascaded diode circuit, and a low-pass filter which is connected to the cascaded diode circuit, characterised in that the primary winding (21) of the transformer (20) is connected to an alternating-voltage source (22) and the amplifier stage (43, 44, 45) contains a rectifier circuit (27, 31, 35; 28, 32, 36; 29, 33, 37) which is connected to the secondary winding (23, 24, 25) of the transformer (20), that the rectifier circuit (27, 31, 35; 28, 32, 36; 29, 33, 37) is provided with at least two outputs, one of which is connected to the cascaded diode circuit (47) via the switching element (39, 40, 41) and the other one of which is directly connected to the cascaded diode circuit (47), and between the two connecting points at least one diode (50, 49, 48) is provided and that the transformers of the amplifier stages (43, 44, 45) are combined into one transformer (20) having a primary winding (21) and a number of secondary windings (23, 24, 25) which corresponds to the number of amplifier stages (43, 44, 45).

2. Switching amplifier according to Claim 1, characterised in that the rectifier circuit has three outputs, two of which are connected to the cascaded diodes circuit (93) via a switching element (91, 92) and the third one of which is directly connected to the cascaded diode circuit (93) which is provided with at least one diode (94, 95) between the first and the third connecting point and between the third and the other connecting point.

3. Switching amplifier according to Claim 1, characterised in that the output voltages of most of the amplifier stages are identical.

4. Switching amplifier according to Claim 1, characterised in that at least one amplifier stage is subdivided into substages and the output voltages of the substages have binary weighting.

5. Switching amplifier according to Claim 1, characterised in that for direct-current isolation of the gate electrode of the switching element (67) from the gating pulse line (72), a device (71) for converting the electric gating pulses into optical signals and another device (70) for reconverting the optical signals into electric gating pulses is provided.

6. Switching amplifier according to Claim 6, characterised in that at optical wave guide (73) is arranged between one and the other device (71 and 70, respectively).

7. Switching amplifier according to Claim 1, characterised in that for direct-current isolation of the gate electrode of the switching elements from the gating pulse line, a device for converting the electric gating pulse into optical signals and switching elements which can be gated by optical signals are provided.

## Claims

1. Switching amplifier for analog LF signals, comprising an A/D converter (11) which converts the analog LF signal into at least two pulse sequences, and comprising at least two amplifier stages (43, 44, 45), each of which contains one transformer (20), the primary winding (21) of which is connected to a voltage source and the secondary winding of which is connected to a diode cascade, and contains at least one switching element, controlled by the pulse sequence, for the current to be transferred from the voltage source to the diode cascade, and comprising a lowpass filter which is connected to the diode cascade, characterised in that the primary winding (21) of the transformer (20) is connected to an alternating-voltage source (22) and the amplifier stage (43, 44, 45) contains a rectifier circuit (27, 31, 35; 28, 32, 36; 29, 33, 37) which is connected to the secondary winding (23, 24, 25) of the transformer (20), and that the rectifier circuit (27, 31, 35; 28, 32, 36; 29, 33, 37) is provided with at least two outputs, one of which is connected to the diode cascade (47) via the switching element (39, 40, 41) and the other one of which is connected directly to the diode cascade (47) and that between the two connection points at least one diode (50, 49, 48) is provided.

2. Switching amplifier according to claim 1, characterised in that the rectifier circuit is provided with three outputs, two of which are connected to the diode cascade (93) via a switching element (91, 92) and the third of which is connected directly to the diode cascade (93), which cascade is provided with at least one diode (94, 95) between one connection point and the third one, as well as between the third connection point and the other one.

3. Switching amplifier according to claim 1, characterised in that the transformers of the amplifier stages (43, 44, 45) are combined to form one transformer (20) having a primary winding (21) and a number of secondary windings (23, 24, 25) corresponding to the number of amplifier stages (43, 44, 45).

4. Switching amplifier according to claim 1, characterised in that the output voltages of most of the amplifier stages are equal.

5. Switching amplifier according to claim 1, characterised in that at least one amplifier stage is subdivided into sub-stages and the output voltages of the sub-stages are given binary weighting.

6. Switching amplifier according to claim 1, characterised in that, for electric isolation of the gating electrode of the switching element (67) from the control pulse line (72), a device (71) for converting the electric control pulses into optical signals and a further device (70) for reconverting the optical signals into electric control pulses are provided.

7. Switching amplifier according to claim 6, characterised in that an optical waveguide (73) is arranged between one device and the further device (71 and 70, respectively).

8. Switching amplifier according to claim 1, characterised in that, for electric isolation of the gating electrode of the switching elements form the control pulse line, a device for converting the electric elements which can be controlled with optical signals are provided.

**Revendications pour les Etats contractants: DE, GB**

1. Amplificateur de commutation pour des signaux A. F. analogiques, comportant un convertisseur analogique/numérique (10) qui convertit le signal A. F. analogique en au moins deux séquences d'impulsions, et au moins deux étages d'amplificateur (42, 44, 45) qui contiennent chacun un transformateur (20) dont le primaire (21) est connecté à une source de tension et le secondaire à une cascade de diodes, et au moins un élément de commutation pilote par la séquence d'impulsions et destiné au courant à transmettre par la source de tension à la cascade de diodes, ainsi qu'un filtre passe-bas connecté à la cascade de diodes, caractérisé en ce que le primaire (21) du transformateur (20) est connecté à une source de tension alternative (22) et l'étage d'amplificateur (43, 44, 45) contient un circuit redresseur (27, 31, 35, 28, 32, 36, 29, 33, 37) connecté au secondaire (23, 24, 25) du transformateur (20), le circuit redresseur (27, 31, 35, 28, 32, 36, 29, 33, 37) présente au moins deux sorties parmi lesquelles la première est connectée par l'intermédiaire de l'élément de commutation (39, 40, 41) et l'autre directement à la cascade de diodes (47) et, entre les deux points de connexion, au moins une diode (50, 49, 48) est prévue, et les transformateurs des étages d'amplificateur (43, 44, 45) sont groupés en un transformateur (20) comportant un primaire (21) et un nombre de secondaire (23, 24, 25) correspondant au nombre d'étages d'amplificateur (43, 44, 45).

2. Amplificateur de commutation suivant la revendiation 1, caractérisé en ce que le circuit redresseur présente trois sorties parmi lesquelles deux sont connectées par l'intermédiaire d'un élément de commutation (91, 92) et la troisième directement à la cascade de diodes (93) qui comporte au mois une diode (94, 95) entre le premier et le troisième point de connexion ainsi qu'entre le troisième et l'autre point de connexion.

3. Amplificateur de commutation suivant la revendication 1, caractérisé en ce que les tensions de sortie de la plupart des étages d'amplificateur sont égales.

4. Amplificateur de commutation suivant la revendication 1, caractérisé en ce qu'au moins un étage d'amplificateur est subdivisé en sous-étages et les tensions de sortie des sous-étages sont pondérées de façon binaire.

5. Amplificateur de commutation suivant la revendication 1, caractérisé en ce que, pour isoler galvaniquement l'électrode de commande de l'élément de commutation (67) de la ligne d'impulsion de commande (72), une disposition (71) destinée à convertir les impulsions de commande élctrique en signaux optiques et un autre dispositif (70) destiné à reconvertir les signaux optiques en impulsions de commande électriques sont prévus.

6. Amplificateur de commutation suivant la revendication 5, caractérisé en ce qu'entre le premier dispositif et l'autre dispositif (71, 70) est disposé un conducteur de lumière (73).

7. Amplificateur de commutation suivant la revendication 1, caractérisé en ce que pour isoler galvaniquement l'électrode de commande des éléments de commutation de la ligne d'impulsion de commande, un dispositif pour convertir les impulsions de commande électriques en des signaux optiques et des éléments de commutation pouvant être pilotes par des signaux optiques sont prévus.

## Revendications

1. Amplificateur à commutation pour signaux analogiques BF, comportant un convertisseur analogique-numérique (11), qui convertit le signal analogique BF en au moins deux trains d'impulsions, au moins deux étages d'amplification (43, 44, 45) comprenant chacun un transformateur (20) dont l'enroulement primaire (1) est raccordé à une source de tension et dont l'enroulement secondaire est relié à une cascade de diodes, et comprenant également au moins un élément de commutation, commandé par le train d'impulsions, pour le courant à transmettre de la source de tension à la cascade de diodes, le dit amplificateur comportant encore un filtre passebas raccordé à la cascade de diodes, caractérisé en ce que l'enroulement primaire (21) du transformateur (20) est raccordé à une source de tension alternative (22), en ce que l'étage d'amplification (43, 44, 45) comprend un circuit redresseur (27, 31, 35; 28, 32, 36; 29, 33, 37) raccordé à l'enroulement secondaire (23, 24, 25) du transformateur (20), en ce que le circuit redresseur (27, 31, 35; 28, 32, 36; 29, 33, 37) présente au moins deux sorties, dont l'une est reliée à la cascade de diodes (47) par l'intermédiaire de l'élément de commutation (39, 40, 41) et dont l'autre est reliée directement à cette cascade de diodes (47), et en ce que, entre les deux points de connexion, il est prévu au moins une diode (50, 49, 48).

2. Amplificateur à commutation suivant la revendication 1 caractérisé en ce que le circuit redresseur présente trois sorties, dont deux sont reliées à la cascade de diodes (93) par l'intermédiaire d'un élément de commutation (91, 92) et dont la troisième est reliée directement à cette cascade de diodes (93), celle-ci comportant au moins une diode (94, 95) entre le premier et le troisième point de connexion et entre le troisième et l'autre point de connexion.

3. Amplificateur à commutation, suivant la revendication 1, caractérisé en ce que les transformateurs des étages d'amplification (43, 44, 45) sont rassemblés en un seul transformateur (20) comportant un enroulement primaire (21) et un nombre d'enroulements secondaires (23, 24, 25) correspondant au nombre d'étages d'amplification (43, 44, 45).

4. Amplificateur à commutation suivant la revendication 1, caractérisé en ce que les tensions de sortie de la plupart des étages d'amplification sont égales.

5. Amplificateur à commutation suivant la revendication 1, caractérisé en ce qu'au moins un étage d'amplification est subdivisé en sous-étages et en ce que les tensions de sortie des sous-étages sont affectées d'un code binaire.

6. Amplificateur à commutation suivant la revendication 1, caractérisé en ce que, pour assurer la séparation électrique de l'électrode de commande de l'élément de commutation (67) et du fil conducteur des impulsions de commande (72), il est prévu un dispositif (71) pour convertir les impulsions électriques de commande en signaux optiques et un autre dispositif (70) pour reconvertir les signaux optiques en impulsions électriques de commande.

7. Amplificateur à commutation suivant la revendication 6, caractérisé en ce qu'un conducteur de lumière (73) est disposé entre l'un et l'autre dispositif (71, respectivement 70).

8. Amplificateur à commutation suivant la revendication 1, caractérisé en ce que, pour assurer la séparation électrique de l'électrode de commande des éléments de commutation et du fil conducteur des impulsions de commande, il est prévu un dispositif pour convertir les impulsions électriques de commande en signaux optiques ainsi que des éléments de commutation pouvant être commandés par des signaux optiques.

Fig. 1

Fig. 2

Fig. 3